# EUROPEAN PATENT APPLICATION

(11) **EP 4 773 743 A1**
(43) Date of publication of application: **08.07.2026**
(21) Application number: 24859996.1
(22) Date of filing: 30.08.2024
(51) Int. Cl.: H05K 3/00, H05K 3/46, H05K 1/02, H10W 70/60, H10P 72/70, H05K 3/02, H10W 70/06

(54) **METHOD FOR MANUFACTURING REDISTRIBUTION STACK, AND CARRIER-ATTACHED METAL FOIL**

(30) Priority: 01.09.2023 JP 2023142509
(71) Applicant: Mitsui Kinzoku Company, Limited, Tokyo 141-8584 (JP)
(72) Inventor: YANAI Takenori, Ageo-shi, Saitama 362-0021 (JP); KITABATAKE Yukiko, Ageo-shi, Saitama 362-0021 (JP); MATSUURA Yoshinori, Ageo-shi, Saitama 362-0021 (JP)
(74) Representative: Potter Clarkson
(86) International application number: PCT/JP2024/031365
(87) International publication number: WO 2025/047971

(57) **Abstract**

There is provided a method for manufacturing a redistribution laminate with which warpage can be reduced. This method for manufacturing a redistribution laminate includes the steps of: forming a first redistribution layer with a thickness of 100 µm or less on a first metal layer of a first carrier-attached metal foil including a first carrier, a first release layer, and the first metal layer in this order to obtain a first laminate; providing a second laminate including a second redistribution layer or dummy insulating layer with a thickness of 100 µm or less on a second carrier; and bonding the first carrier of the first laminate and the second carrier of the second laminate via an adhesive layer containing an adhesive material to obtain a third laminate.

## Description

### TECHNICAL FIELD

The present disclosure relates to a method for manufacturing a redistribution laminate, and a carrier-attached metal foil.

### BACKGROUND ART

In recent years, multilayering of printed wiring boards has become widespread to increase the mounting density of the printed wiring boards for size reduction. Such multilayer printed wiring boards have been in use in many portable electronic apparatuses to reduce weight and size. These multilayer printed wiring boards have been required to have further reductions in the thicknesses of interlayer insulating layers and to still further weight reductions as wiring boards.

As a technique for satisfying such requirements, a method for manufacturing a multilayer printed wiring board using a coreless build-up method has been adopted. The coreless build-up method is a method of alternately laminating (building up) insulating layers and wiring layers for multilayering, without using a so-called core substrate. For the coreless build-up method, using a carrier-attached copper foil has been proposed to enable easy release of a support and a multilayer printed wiring board from each other. For example, Patent Literature 1 (JP2005-101137A) discloses a method for manufacturing a package substrate for semiconductor device mounting, the method including affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of an embedded circuit as shown in Patent Literature 1, a carrier-attached copper foil in which the thickness of a superthin copper layer is 1 µm or less is desired. Therefore, it has been proposed to use a vapor phase method, such as sputtering, to form a superthin copper layer and achieve a reduction in the thickness of the superthin copper layer. For example, Patent Literature 2 (WO2017/150283) discloses a carrier-attached copper foil in which a release layer, an antireflection layer, and a superthin copper layer are formed on a carrier such as glass or ceramic by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as glass or ceramic by sputtering. Patent Literatures 2 and 3 also teach that intermediate layers composed of predetermined metals are interposed, thus providing excellent stability of the mechanical release strength of the carrier, and that the antireflection layer exhibits a desirable dark color, thus improving visibility in image inspection (for example, automatic image inspection (AOI)).

Especially, with still further size reduction and power saving of electronic devices, there is a growing need for the high integration and thinning of semiconductor chips and printed wiring boards. As next-generation packaging techniques for satisfying such a need, the adoption of fan-out wafer level packaging (FO-WLP) and panel level packaging (PLP) has been studied in recent years. The adoption of the coreless build-up method has also been studied for FO-WLP and PLP. One such method is a method referred to as a redistribution layer-first (RDL-first) method in which a wiring layer and, if necessary, a build-up wiring layer are formed on a coreless support surface, and, if necessary, the support is released, followed by mounting of chips. For example, Patent Literature 4 (JP2015-35551A) discloses a method for manufacturing a semiconductor apparatus, the method including forming a metal release layer on the main surface of a support composed of glass or a silicon wafer, forming an insulating resin layer on the metal release layer, forming a redistribution layer including build-up layers on the insulating resin layer, mounting and sealing semiconductor integrated circuits on the redistribution layer, exposing the release layer by the removal of the support, exposing secondary mounting pads by the removal of the release layer, and forming solder bumps on the surfaces of the secondary mounting pads, and performing secondary mounting.

Meanwhile, in recent years, a method called a 2.1-dimensional (2.1D) package manufacturing method, in which a redistribution layer including fine wiring is formed on a conventional build-up substrate, has been proposed. For example, Patent Literature 5 (JP6298722B) discloses that, after forming a first wiring structure having wiring layers with a low wiring density on both upper and lower surfaces of a core substrate by a build-up method, a second wiring structure having wiring layers with a high wiring density is formed on an upper surface of an insulating layer formed on the uppermost layer of the first wiring structure.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: JP6298722B

### SUMMARY OF INVENTION

However, in the case where a redistribution layer including fine wiring is formed on a build-up substrate as disclosed in Patent Literature 5, there is a problem in that it becomes difficult to form wiring as intended due to the surface roughness of a prepreg or the like used in the build-up substrate. In order to address such a problem, it may be considered to manufacture a laminate including a redistribution layer (sometimes referred to as "redistribution laminate") by forming a redistribution layer on one side (on a metal layer) of a carrier-attached metal foil, and further forming a build-up layer on the redistribution layer. However, the laminate thus manufactured may suffer from significant warpage, which can make it difficult to carry out the subsequent mounting step and the like.

The present inventors have now found that a redistribution laminate with reduced warpage can be prepared by forming a first redistribution layer with a thickness of 100 µm or less on a metal layer of a carrier-attached metal foil to obtain a first laminate, and then bonding a predetermined second laminate to the first laminate via an adhesive layer.

Accordingly, an object of the present invention is to provide a method for manufacturing a redistribution laminate with which warpage can be reduced. Another object of the present invention is to provide a carrier-attached metal foil capable of manufacturing such a redistribution laminate.

The present invention provides the following aspects:
[Aspect 1] A method for manufacturing a redistribution laminate, comprising the steps of:
   forming a first redistribution layer with a thickness of 100 µm or less on a first metal layer of a first carrier-attached metal foil comprising a first carrier, a first release layer, and the first metal layer in this order to obtain a first laminate;
   providing a second laminate comprising a second redistribution layer or dummy insulating layer with a thickness of 100 µm or less on a second carrier; and
   bonding the first carrier of the first laminate and the second carrier of the second laminate via an adhesive layer containing an adhesive material to obtain a third laminate.
[Aspect 2] The method for manufacturing a redistribution laminate according to aspect 1, further comprising the step of forming a first build-up layer on the first redistribution layer of the third laminate and also forming a second build-up layer on the second redistribution layer or dummy insulating layer of the third laminate to obtain a fourth laminate.
[Aspect 3] The method for manufacturing a redistribution laminate according to aspect 2, further comprising the step of releasing the first carrier from the fourth laminate.
[Aspect 4] The method for manufacturing a redistribution laminate according to any one of aspects 1 to 3,
   wherein the second laminate comprises the second redistribution layer, and
   wherein the step of providing the second laminate comprises forming the second redistribution layer on a second metal layer of a second carrier-attached metal foil comprising the second carrier, a second release layer, and the second metal layer in this order.
[Aspect 5] The method for manufacturing a redistribution laminate according to any one of aspects 1 to 4, wherein each of the first carrier and the second carrier has a coefficient of linear thermal expansion of 2.0 ppm/K or more and 30.0 ppm/K or less.
[Aspect 6] The method for manufacturing a redistribution laminate according to any one of aspects 1 to 5, wherein a ratio T_{R2}/T_{R1} of a thickness T_{R2} of the second redistribution layer or the dummy insulating layer to a thickness T_{R1} of the first redistribution layer is 0.1 or more and 30.0 or less.
[Aspect 7] The method for manufacturing a redistribution laminate according to any one of aspects 1 to 6,
   wherein the step of forming the first redistribution layer comprises the steps of:
   forming a first wiring layer on a surface of the first metal layer; and
   alternately forming an insulating layer and a wiring layer on the surface of the first carrier-attached metal foil where the first wiring layer has been formed to obtain the first redistribution layer in which the first wiring layer is incorporated as an embedded wiring layer.
[Aspect 8] The method for manufacturing a redistribution laminate according to aspect 7, wherein the insulating layer is composed of an insulating resin comprising at least one selected from the group consisting of a thermosetting epoxy resin, a thermosetting polyimide resin, and a thermosetting phenolic resin.
[Aspect 9] The method for manufacturing a redistribution laminate according to any one of aspects 1 to 8, wherein the adhesive material comprises a solvent-free adhesive.
[Aspect 10] The method for manufacturing a redistribution laminate according to any one of aspects 1 to 9, wherein the adhesive material comprises at least one selected from the group consisting of a thermosetting epoxy resin, a thermosetting polyimide resin, a photosensitive polyimide resin, an acrylic resin, and a phenolic resin.
[Aspect 11] The method for manufacturing a redistribution laminate according to any one of aspects 1 to 10, wherein the adhesive layer has a thickness of 5 µm or more and 1000 µm or less.
[Aspect 12] The method for manufacturing a redistribution laminate according to any one of aspects 2 to 11, wherein each of the first build-up layer and the second build-up layer has a thickness of 20 µm or more.
[Aspect 13] The method for manufacturing a redistribution laminate according to any one of aspects 2 to 12, wherein a ratio T_{B2}/T_{B1} of a thickness T_{B2} of the second build-up layer to a thickness T_{B1} of the first build-up layer is 0.5 or more and 1.5 or less.
[Aspect 14] The method for manufacturing a redistribution laminate according to any one of aspects 2 to 13, wherein each of the first build-up layer and the second build-up layer comprises a prepreg.
[Aspect 15] A carrier-attached metal foil comprising:
   a first carrier;
   a first release layer provided on the first carrier;
   a first metal layer provided on the first release layer;
   an adhesive layer containing an adhesive material, provided on a surface of the first carrier on an opposite side to the first release layer; and
   a second carrier provided on the first carrier via the adhesive layer.
[Aspect 16] The carrier-attached metal foil according to aspect 15, further comprising:
   a second release layer provided on the second carrier; and
   a second metal layer provided on the second release layer.
[Aspect 17] A laminate comprising:
   the carrier-attached metal foil according to aspect 16;
   a first redistribution layer provided on the first metal layer of the carrier-attached metal foil; and
   a second redistribution layer or an insulating layer provided on the second metal layer of the carrier-attached metal foil.
[Aspect 18] The laminate according to aspect 17, further comprising:
   a first build-up layer provided on the first redistribution layer; and
   a second build-up layer provided on the second redistribution layer or the insulating layer.

### BRIEF DESCRIPTION OF DRAWINGS

Figure 1 is a process flow chart illustrating an example of the method for manufacturing a redistribution laminate of the present invention, shown as schematic cross-sectional views, corresponding to the initial steps (steps (i) to (iii)).
Figure 2 is a process flow chart illustrating an example of the method for manufacturing a redistribution laminate of the present invention, shown as schematic cross-sectional views, corresponding to the intermediate steps (steps (iv) to (vi)) following the steps shown in Figure 1.
Figure 3 is a process flow chart illustrating an example of the method for manufacturing a wiring substrate of the present invention, shown as schematic cross-sectional views, corresponding to the later steps (steps (vii) and (viii)) following the steps shown in Figure 2.
Figure 4 is a photograph showing the warpage of the first laminate prepared in Example 1.
Figure 5 is a photograph showing the warpage of the third laminate prepared in Example 1.
Figure 6 is a process flow chart illustrating an example of procedures for preparing the carrier-attached metal foil of the present invention, shown as schematic cross-sectional views.

### DESCRIPTION OF EMBODIMENTS

### Method for Manufacturing Redistribution Laminate

The present invention relates to a method for manufacturing a redistribution laminate. The method of the present invention includes the steps of: (1) preparing a first laminate; (2) providing a second laminate; (3) bonding the first laminate and the second laminate; (4) optionally forming a first build-up layer and a second build-up layer; and (5) optionally releasing the first carrier. Each of the steps (1) to (5) will be described below with reference to the drawings.

### (1) Preparing First Laminate

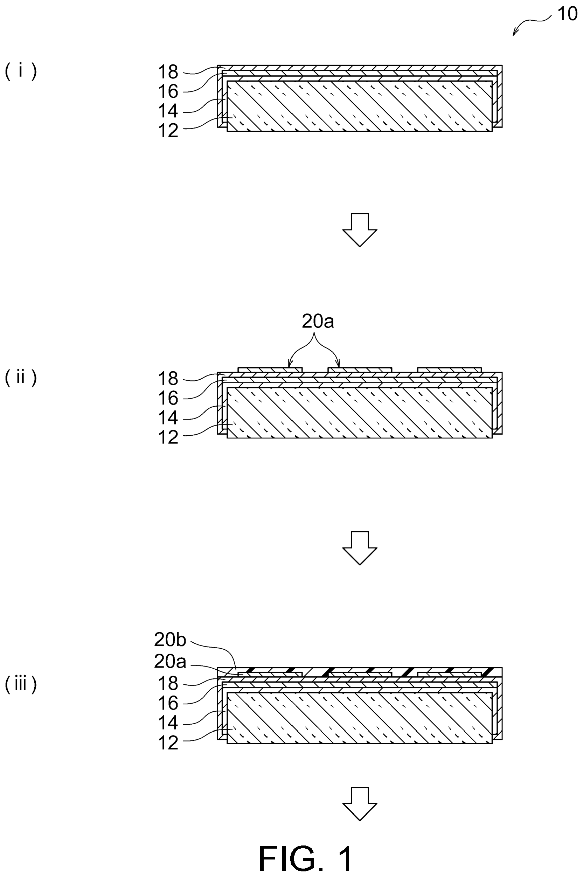

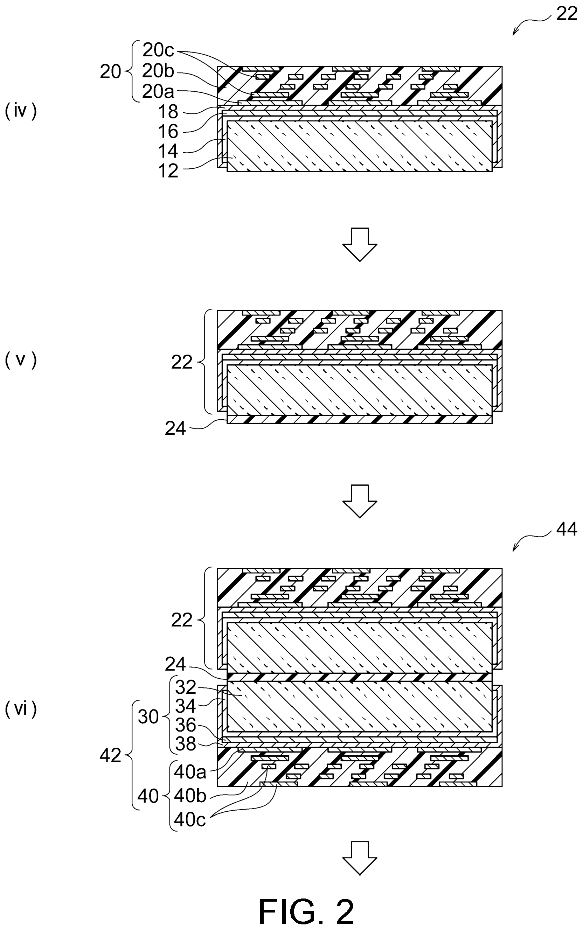

An example of the method for manufacturing a redistribution laminate of the present invention is illustrated in Figures 1 to 3. First, as shown in Figures 1(i) to 2(iv), a first redistribution layer 20 with a thickness of 100 µm or less is formed on a first metal layer 18 of a first carrier-attached metal foil 10 including a first carrier 12, a first release layer 16, and the first metal layer 18 in this order to obtain a first laminate 22. In the present invention, the redistribution layer refers to a layer including an insulating layer and a wiring layer formed inside and/or on the surface of the insulating layer. The first release layer 16 is a layer that is provided on the first carrier 12 and contributes to the release of the first carrier 12 and the first metal layer 18 from each other. The first metal layer 18 is a layer composed of a metal provided on the first release layer 16. The first carrier-attached metal foil 10 may further include a first intermediate layer 14 between the first carrier 12 and the first release layer 16, which can contribute to improved adhesion. Preferred aspects of the first carrier 12, the first intermediate layer 14, the first release layer 16, and the first metal layer 18 will be described later.

As described above, in the case where a redistribution layer including fine wiring is formed on a build-up substrate as disclosed in Patent Literature 5, there is a problem in that it becomes difficult to form fine wiring as intended due to the surface roughness (waviness) of a prepreg or the like used in the build-up substrate. In this regard, even in the case where the surface of the prepreg is subjected to chemical mechanical polishing (CMP), it is generally difficult to flatten the prepreg to an extent sufficient to allow fine wiring to be formed as intended. In contrast, according to the method of the present invention, the first redistribution layer 20 is first formed on the flat surface of the first carrier-attached metal foil 10, making it easier to form fine wiring as intended. In addition, by forming the first redistribution layer 20 with a thickness as thin as 100 µm or less, the warpage of the first redistribution layer 20 itself can be reduced to a handleable range, thereby enabling the subsequent steps described later to be performed.

Accordingly, the thickness T_{R1} of the first redistribution layer 20 is 100 µm or less, preferably 5 µm or more and 95 µm or less, more preferably 7 µm or more and 90 µm or less, further preferably 9 µm or more and 80 µm or less, and particularly preferably 10 µm or more and 70 µm or less. In addition, the first redistribution layer 20 preferably includes a wiring pattern with a line/space (L/S) of 10 µm or less/10 µm or less, and more preferably includes a wiring pattern with a line/space of 5 µm or less/5 µm or less. The lower limit of the line/space (L/S) in the wiring pattern is not particularly limited, but is typically 1 µm or more/1 µm or more.

The formation of the first redistribution layer 20 can be preferably carried out as follows, for example. First, as shown in Figure 1(ii), a first wiring layer 20a is formed on the surface of the first metal layer 18 in the first carrier-attached metal foil 10. Typically, the formation of the first wiring layer 20a is carried out according to a known method, involving formation of a photoresist layer, formation of an electrolytic copper plating layer, removal of the photoresist layer, and optionally, copper flash etching. For example, the procedure is as follows. First, a photoresist layer is formed on the surface of the first metal layer 18 in a predetermined pattern. The photoresist is preferably a photosensitive film, such as a photosensitive dry film. The photoresist layer may be given a predetermined wiring pattern by exposure and development. An electrolytic copper plating layer is formed on the exposed surface of the first metal layer 18 (that is, the part not masked by the photoresist layer). The electrolytic copper plating may be carried out by a known method and is not particularly limited. Next, the photoresist layer is removed. As a result, the electrolytic copper plating layer remains in the form of wiring pattern, thereby forming the first wiring layer 20a.

Next, as shown in Figures 1(iii) and 2(iv), an insulating layer 20b and a wiring layer 20c are alternately formed on the surface of the first carrier-attached metal foil 10 where the first wiring layer 20a has been formed. In this way, the first redistribution layer 20 is obtained in which the first wiring layer 20a is incorporated as an embedded wiring layer. The method for forming the insulating layer 20b and the wiring layer 20c is not particularly limited, and known methods can be adopted. For example, the insulating layer 20b can be preferably formed by laminating an insulating resin material and carrying out a heat curing treatment. Optionally, the formation of the insulating layer 20b and the wiring layer 20c may be carried out through known steps such as via processing, desmear, copper plating, and circuit formation. Preferred examples of the insulating resin constituting the insulating layer 20b include a thermosetting epoxy resin, a thermosetting polyimide resin, a thermosetting phenolic resin, and a combination thereof, with a thermosetting polyimide resin being more preferable. The insulating layer 20b may contain a curing agent, filler, or the like. Moreover, the thickness of each wiring layer constituting the first redistribution layer 20 is not particularly limited, but is typically 1 µm or more and 20 µm or less.

### (2) Providing Second Laminate

A second laminate 42 including a second redistribution layer 40 or dummy insulating layer (not shown) with a thickness of 100 µm or less on a second carrier 32 is provided (see Figure 2(vi)). The term "dummy insulating layer" refers to a layer composed of an insulating layer without a wiring layer, which functions as a dummy for the redistribution layer.

The second laminate 42 is laminated on the first laminate 22 described above and contributes to suppressing warpage of the first redistribution layer 20 (and furthermore, a first build-up layer 46 described later). Here, warpage of the laminate typically occurs in a process involving heating (for example, a heat curing treatment of an insulating layer) due to a difference between the coefficient of linear thermal expansion of the material constituting the carrier and the coefficient of linear thermal expansion of the material constituting the insulating layer. For this reason, for example, in the case where the first redistribution layer 20 and the first build-up layer 46 described later are formed only on one side of the first carrier-attached metal foil 10, significant warpage may occur in the manufactured redistribution laminate. In contrast, according to the method of the present invention, a stress opposite to the stress (warping force) of the first redistribution layer 20 and the first build-up layer 46 (if present) is applied to the laminate from the second redistribution layer 40 or dummy insulating layer and a second build-up layer 48 described later (if present). In this manner, the stresses can cancel each other out, thereby suppressing warpage of the redistribution laminate.

In addition, as described above, the method of the present invention separately provides the first laminate 22 including the first redistribution layer 20 and the second laminate 42 including the second redistribution layer 40 (or dummy insulating layer). Therefore, compared with a method in which a carrier-attached metal foil having release layers and metal layers on both surfaces of a carrier is used and redistribution layers including fine wiring are simultaneously formed on both surfaces of the carrier-attached metal foil, the method of the present invention offers excellent handleability and also has the advantage that problems such as quality troubles caused by the high degree of manufacturing difficulty are less likely to occur.

The first carrier 12 and the second carrier 32 each preferably have a coefficient of linear thermal expansion (CTE) of 2.0 ppm/K or more and 30.0 ppm/K or less, more preferably 2.5 ppm/K or more and 25.0 ppm/K or less, further preferably 3.0 ppm/K or more and 20.0 ppm/K or less, and particularly preferably 3.2 ppm/K or more and 15.0 ppm/K or less. Within such a range, warpage of the carrier itself in a process involving a heat treatment can be suppressed, and warpage of the laminate based on the difference in the coefficient of linear thermal expansion between the carrier and the insulating layer can also be suppressed even more effectively.

The thickness T_{R} of the second redistribution layer 40 or dummy insulating layer is 100 µm or less, preferably 10 µm or more and 90 µm or less, more preferably 20 µm or more and 80 µm or less, further preferably 30 µm or more and 70 µm or less, and particularly preferably 40 µm or more and 60 µm or less. In addition, the ratio T_{R2}/T_{R1} of the thickness T_{R2} of the second redistribution layer 40 or dummy insulating layer to the thickness T_{R1} of the first redistribution layer 20 is preferably 0.1 or more and 30.0 or less, more preferably 0.2 or more and 10 or less, further preferably 0.5 or more and 5.0 or less, particularly preferably 0.7 or more and 3.0 or less, and most preferably 0.8 or more and 2.0 or less. Within such a range, a stress of approximately the same level as the stress of the first redistribution layer 20 is applied to the laminate from the second redistribution layer 40 or dummy insulating layer during a process involving a heat treatment, and as a result, warpage of the redistribution laminate can be suppressed even more effectively.

In the case where the second laminate 42 includes the second redistribution layer 40, it is preferable to form the redistribution layer using a carrier-attached metal foil in the same manner as in the first laminate 22 described above. That is, as shown in Figure 2(vi), it is preferable to form the second redistribution layer 40 on a second metal layer 38 of a second carrier-attached metal foil 30 including a second carrier 32, a second release layer 36, and the second metal layer 38 in this order. In addition, the formation of the second redistribution layer 40 is preferably carried out by forming a first wiring layer 40a on the surface of the second metal layer 38, and then alternately forming an insulating layer 40b and a wiring layer 40c on the surface of the second carrier-attached metal foil 30 where the first wiring layer 40a has been formed. The second carrier-attached metal foil 30 may further include a second intermediate layer 34 between the second carrier 32 and the second release layer 36, which can contribute to improved adhesion. Preferred aspects of the first carrier-attached metal foil 10 and the first laminate 22 also apply to the second carrier-attached metal foil 30 and the second laminate 42, respectively. That is, the second carrier 32, the second intermediate layer 34, the second release layer 36, the second metal layer 38, and the second redistribution layer 40 can correspond to the first carrier 12, the first intermediate layer 14, the first release layer 16, the first metal layer 18, and the first redistribution layer 20, respectively.

Meanwhile, in the case where the second laminate 42 includes the dummy insulating layer, the dummy insulating layer may be formed directly on the surface of the second carrier 32. However, in the same manner as in the second redistribution layer 40 described above, it is permissible to form the dummy insulating layer on the second metal layer 38 of the second carrier-attached metal foil 30. The formation of the dummy insulating layer may follow the formation of the insulating layer 20b constituting the first redistribution layer 20 and is not particularly limited. Moreover, the preferred aspects of the insulating layer 20b described above are also applicable to the dummy insulating layer as they are. The constituent materials of the dummy insulating layer may be the same as or different from the constituent materials of the insulating layer 20b. For example, it is permissible to constitute the dummy insulating layer from an insulating resin material or the like that is less expensive than the insulating layer 20b.

### (3) Bonding First Laminate and Second Laminate

As shown in Figures 2(v) and (vi), the first carrier 12 of the first laminate 22 and the second carrier 32 of the second laminate 42 are bonded via an adhesive layer 24 containing an adhesive material to obtain a third laminate 44. By thus achieving a configuration in which insulating layers are symmetrically arranged on both surfaces of the laminate, the stresses of the insulating layers cancel each other out during the subsequent process involving heating, thereby suppressing warpage of the redistribution laminate. Also, even in the case where the first laminate 22 and the second laminate 42 have warpage to an extent that allows handling, bonding them via the adhesive layer 24 allows the adhesive layer 24 to absorb (flatten) irregularities caused by such warpage.

The adhesive layer 24 is preferably a layer that allows the first laminate 22 and the second laminate 42 to be adhered with desired adhesion. The adhesion mode between the first laminate 22 and the second laminate 42 via the adhesive layer 24 is not particularly limited, and may be, for example, mechanical bonding (that is, adhesion by an anchor effect), physical interaction (that is, adhesion by van der Waals force), chemical bonding, or the like. Examples of the adhesive material contained in the adhesive layer 24 include a phenolic resin, a urea resin, a melamine resin, an epoxy resin, a polyimide resin, an ethylene-vinyl acetate copolymer resin (EVA), a urethane resin, an acrylic resin, a synthetic rubber, a starch, and a silicone resin, with a thermosetting epoxy resin, a thermosetting polyimide resin, a photosensitive polyimide resin, an acrylic resin, a phenolic resin, or a combination thereof being preferable. The method for bonding the first laminate 22 and the second laminate 42 is also not particularly limited, and the bonding may be preferably carried out by a method such as roll lamination or vacuum lamination.

The adhesive layer 24 is preferably capable of maintaining adhesiveness even after a heating treatment at a high temperature (for example, 190°C or higher). From this viewpoint, it is preferable that the adhesive material contains a thermosetting resin. Preferred examples of the thermosetting resin include a thermosetting epoxy resin, a thermosetting polyimide resin, a thermosetting phenolic resin, a thermosetting melamine resin, and a combination thereof, with a thermosetting epoxy resin being more preferable. In particular, it is preferable that the adhesive material includes a solvent-free adhesive. In this way, the generation of gas accompanying the heating treatment can be suppressed, making it much easier to maintain the adhesiveness between the first laminate 22 and the second laminate 42. Examples of products of the solvent-free adhesive film containing a thermosetting epoxy resin include TSA-1602 manufactured by Toray Industries, Inc. In the case where the adhesive layer 24 contains a thermosetting resin as the adhesive material, it is preferable to perform a heat curing treatment after bonding the first laminate 22 and the second laminate 42. The conditions for the heat curing treatment may be determined as appropriate depending on the thermosetting resin to be used, and are not particularly limited.

The adhesive layer 24 preferably has a thickness of 5 µm or more and 1000 µm or less, more preferably 7 µm or more and 800 µm or less, further preferably 10 µm or more and 500 µm or less, and particularly preferably 20 µm or more and 300 µm or less. With such a thickness, it becomes easier to control the adhesion between the first laminate 22 and the second laminate 42 within a desired range, and the irregularities caused by warpage of the first laminate 22 and the second laminate 42 can be absorbed even more easily.

The method for forming the adhesive layer 24 is not particularly limited, and known methods can be adopted. For example, the adhesive layer 24 can be formed by applying a coating solution in which the adhesive material is dissolved in a solvent onto the first carrier 12 or the second carrier 32 and drying it to evaporate the solvent. Alternatively, a commercially available adhesive film may be placed on the first carrier 12 or the second carrier 32 and then bonded by a method such as roll lamination or vacuum lamination.

### (4) Forming First Build-up Layer and Second Build-up Layer (Optional Step)

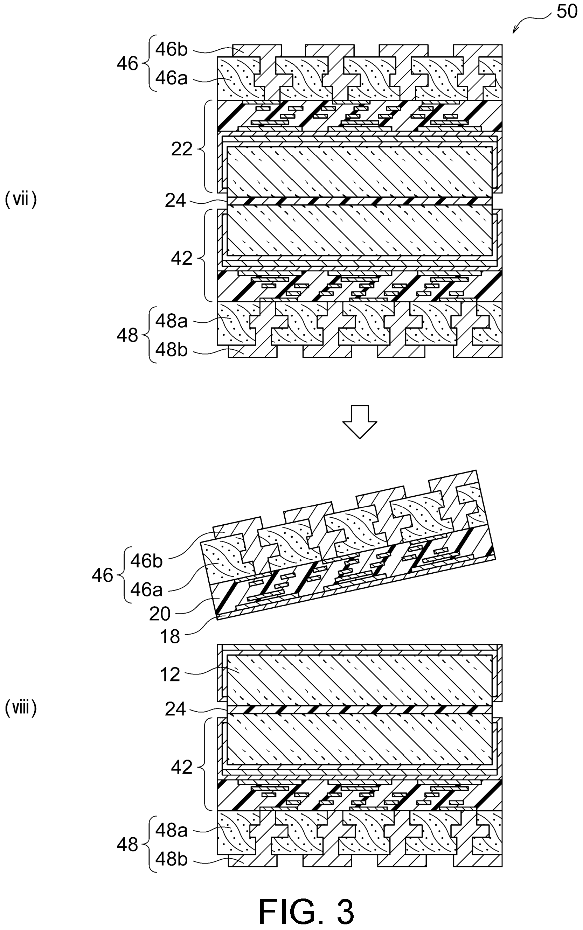

Optionally, as shown in Figure 3(vii), a first build-up layer 46 is formed on the first redistribution layer 20 of the third laminate 44, and a second build-up layer 48 is also formed on the second redistribution layer 40 or dummy insulating layer of the third laminate 44 to obtain a fourth laminate 50. By forming the build-up layers symmetrically on both surfaces of the laminate in this manner, the stresses of the insulating layers contained in the first build-up layer 46 and the second build-up layer 48 cancel each other out during a process involving heating, thereby suppressing warpage of the redistribution laminate.

The first build-up layer 46 can be prepared by alternately laminating and multilayering a wiring layer 46a and an insulating layer 46b by the known coreless build-up method described above. For example, the formation of the first build-up layer 46 is carried out through various steps such as lamination and curing treatment of the insulating layer, via processing, desmear, copper plating, and circuit formation. The thickness T_{B1} of the first build-up layer 46 is preferably 20 µm or more, more preferably 30 µm or more and 300 µm or less, further preferably 40 µm or more and 250 µm or less, particularly preferably 50 µm or more and 200 µm or less, and most preferably 60 µm or more and 150 µm or less.

The second build-up layer 48 can have a configuration similar to that of the first build-up layer 46, and preferably includes a wiring layer 48a and an insulating layer 48b, for example. However, in the case where the second laminate 42 includes the dummy insulating layer instead of the second redistribution layer 40, for example, the second build-up layer 48 may not include the wiring layer 48a and may be composed of the insulating layer 48b (that is, a dummy layer).

The wiring layer 46a and the wiring layer 48a, which may be included in the first build-up layer 46 and the second build-up layer 48, respectively, typically have a line/space (L/S) larger than the wiring patterns included in the first redistribution layer 20 and the second redistribution layer 40. The typical line/space (L/S) of each of the wiring layer 46a and the wiring layer 48a is 5 µm or more/5 µm or more to 30 µm or less/30 µm or less, and more typically more than 10 µm/more than 10 µm to 30 µm or less/30 µm or less.

The preferred thickness of the first build-up layer 46 described above is also applicable to the second build-up layer 48 as it is. In addition, the ratio T_{B2}/T_{B1} of the thickness T_{B2} of the second build-up layer 48 to the thickness T_{B1} of the first build-up layer 46 is preferably 0.5 or more and 1.5 or less, more preferably 0.6 or more and 1.4 or less, further preferably 0.7 or more and 1.3 or less, and particularly preferably 0.8 or more and 1.2 or less. Within such a range, the stress of the first build-up layer 46 and the stress of the second build-up layer 48 become approximately the same level during a process involving a heat treatment, and as a result, warpage of the redistribution laminate can be suppressed even more effectively.

The first build-up layer 46 and the second build-up layer 48 typically each include a prepreg as the insulating layer. The prepreg is a generic term for a composite material in which a substrate such as synthetic resin plate, glass plate, glass woven fabric, glass non-woven fabric, or paper is impregnated with a synthetic resin, or a synthetic resin is laminated thereon. Preferred examples of the insulating resin with which the prepreg is impregnated include an epoxy resin, a cyanate resin, a bismaleimide-triazine (BT) resin, a polyphenylene ether resin, a phenolic resin, and a polyamide resin. The insulating layer may contain a curing agent, filler, or the like. However, the constituent materials of the insulating layer 46b included in the first build-up layer 46 may be the same as or different from the constituent materials of the insulating layer 48b included in the second build-up layer 48. For example, in the case where the second build-up layer 48 is configured as the dummy layer described above, it is permissible to use a less expensive insulating resin material or the like to constitute the second build-up layer 48.

### (5) Releasing First Carrier (Optional Step)

Optionally, as shown in Figure 3(viii), the first carrier 12 is released from the fourth laminate 50. By doing so, the first redistribution layer 20 and the first build-up layer 46 can be separated at the position of the first release layer 16. It is preferable that the release of the first carrier 12 is carried out by a laser lift-off method in which release is performed with a laser, or by a mechanical method in which release is performed by applying a physical force using a machine.

After releasing the first carrier 12, the first release layer 16 and the first metal layer 18 remaining on the first redistribution layer 20 may be removed. The method for removing the first release layer 16 and the first metal layer 18 is not particularly limited, and a known method may be selected as appropriate depending on the material of the first release layer 16 and the first metal layer 18, and other factors. For example, in the case where the first release layer 16 is a carbon layer, the first release layer 16 can be preferably removed by carrying out an oxygen plasma treatment on the laminate. In addition, the removal of the first metal layer 18 can be carried out by, for example, bringing it into contact with an etching solution capable of dissolving the first metal layer 18.

After removing the first release layer 16 and the first metal layer 18, various electronic elements such as a chip may be mounted on the first redistribution layer 20 by a known method, and resin sealing may be performed. Examples of the electronic elements include semiconductor elements, chip capacitors, and resistors. In addition, a solder resist, a bump for mounting, or the like may be formed on the outer layer surface of the first build-up layer 46.

In the case where the second laminate 42 includes the second redistribution layer 40, for example, the second carrier 32 may be further released from the fourth laminate 50, thereby allowing the second redistribution layer 40 and the second build-up layer 48 to be separated at the position of the second release layer 36. The preferred aspects described above regarding the release of the first carrier 12 and the subsequent steps are also applicable to the release of the second carrier 32 and the subsequent steps as they are.

### Carrier-Attached Metal Foil

According to another preferred aspect of the present invention, there is provided a carrier-attached metal foil. This carrier-attached metal foil includes a first carrier 12, a first release layer 16, a first metal layer 18, an adhesive layer 24, and a second carrier 32. The first release layer 16 is provided on the first carrier 12. The first metal layer 18 is provided on the first release layer 16. The adhesive layer 24 contains an adhesive material and is provided on the surface of the first carrier 12 on the opposite side to the first release layer 16. The second carrier 32 is provided on the first carrier 12 via the adhesive layer 24. The carrier-attached metal foil may further include a first intermediate layer 14 between the first carrier 12 and the first release layer 16. Moreover, the carrier-attached metal foil may further include a second release layer 36 provided on the second carrier 32, and a second metal layer 38 provided on the second release layer 36, and may further include a second intermediate layer 34 between the second carrier 32 and the second release layer 36. This carrier-attached metal foil constitutes, typically in the method for manufacturing a redistribution laminate described above, the third laminate 44 after bonding the first laminate 22 and the second laminate 42, and therefore, by using this carrier-attached metal foil, it is possible to manufacture a redistribution laminate in which warpage is suppressed.

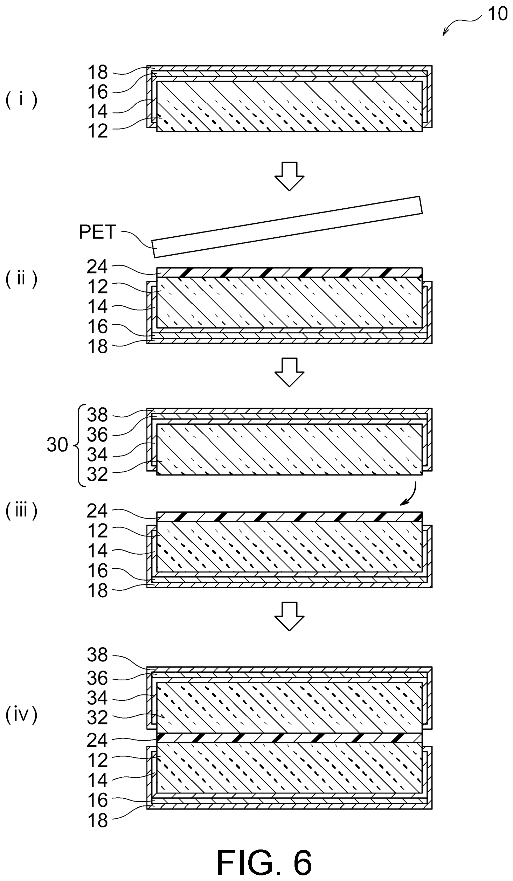

Alternatively, the carrier-attached metal foil of the present invention may be one in which a first carrier-attached metal foil 10 and a second carrier 32 are bonded via an adhesive layer 24, as shown in the examples described later. Specifically, as shown in Figure 6, a first carrier-attached metal foil 10 including a first carrier 12, optionally a first intermediate layer 14 (an optional layer), a first release layer 16, and a first metal layer 18 can be provided (Figure 6(i)), an adhesive layer 24 can be laminated onto the first carrier 12 (Figure 6(ii)), and the second carrier 32 can be further laminated onto the adhesive layer 24 (Figure 6(iii)), thereby forming the carrier-attached metal foil of the present invention. With such a configuration, when a laminate is formed by further laminating redistribution layers and/or build-up layers having different coefficients of thermal expansion, warpage of the laminate can be suppressed effectively. The second carrier 32 may be provided in the form of a second carrier-attached metal foil 30, as shown in Figure 6(iii). The second carrier-attached metal foil 30 includes the second carrier 32, optionally a second intermediate layer 34 (an optional layer), a second release layer 36, and a second metal layer 38 in this order. From the viewpoint of suppressing warpage of the laminate even more effectively, it is particularly preferable that the first carrier-attached metal foil 10 and the second carrier-attached metal foil 30 have the same layer configuration. That is, according to a preferred aspect of the present invention, the carrier-attached metal foil has the first carrier-attached metal foil 10 and the second carrier-attached metal foil 30 arranged in an up-down symmetric manner via the adhesive layer 24. Specifically, in the carrier-attached metal foil, it is preferable that the materials and thicknesses of the first carrier 12 and the second carrier 32 are the same, it is preferable that the materials and thicknesses of the first intermediate layer 14 and the second intermediate layer 34 are the same, it is preferable that the materials and thicknesses of the first release layer 16 and the second release layer 36 are the same, and it is preferable that the materials and thicknesses of the first metal layer 18 and the second metal layer 38 are the same. Here, "the same" is not limited to cases where the materials and thicknesses of the corresponding layers are completely identical, and may include cases where they are substantially the same to the extent that no warpage occurs in the laminate.

Preferred aspects of the first carrier 12, the first intermediate layer 14, the first release layer 16, and the first metal layer 18 will be described below, but these preferred aspects are also applicable to the second carrier 32, the second intermediate layer 34, the second release layer 36, and the second metal layer 38 as they are.

The first carrier 12 is preferably composed of glass, silicon, ceramic, resin, metal, or a combination thereof, more preferably of glass, silicon, or ceramic, and further preferably of glass or silicon. The first carrier 12 composed of silicon may be any carrier as long as it contains Si as an element, and a SiO₂ substrate, a SiN substrate, a Si single crystal substrate, and a Si polycrystalline substrate, or the like can be applied. According to a preferred aspect of the present invention, the first carrier 12 has a disk shape with a diameter of 100 mm or more, and more preferably a disk shape with a diameter of 200 mm or more and 450 mm or less. Note that the first carrier 12 (for example, a Si single crystal substrate) may have a notch or an orientation flat in order to indicate a reference point of the crystal orientation. In general, when the diameter of the first carrier 12 is 200 mm or less, an orientation flat is formed, and when it is 200 mm or more, a notch is formed. According to another preferred aspect of the present invention, the first carrier 12 has a rectangular shape with a short side of 100 mm or more, and more preferably a short side of 150 mm or more and 650 mm or less. The rectangular first carrier 12 may have a roll shape with its long side sufficiently longer than its short side, and preferably has a long side of 200 mm or more and 650 mm or less.

The form of the first carrier 12 may be any one of a sheet, a film, and a plate. The first carrier 12 may be a laminate of these sheets, films, plates, and the like. For example, the first carrier 12 may be one that can function as a support having rigidity, such as a glass plate, a ceramic plate, a silicon wafer, or a metal plate, or may be in the form of having no rigidity, such as a metal foil or a resin film. Preferred examples of the metal constituting the first carrier 12 include copper, titanium, nickel, stainless steel, and aluminum. Preferred examples of the ceramic include alumina, zirconia, silicon nitride, aluminum nitride, and various other fine ceramics. Preferred examples of the resin include polyethylene terephthalate (PET), polyethylene naphthalate (PEN), polyamides, polyimides, nylons, liquid crystal polymers, polyetheretherketone (PEEK (^{®})), polyamide-imides, polyethersulfone, polyphenylene sulfide, polytetrafluoroethylene (PTFE), and ethylene tetrafluoroethylene (ETFE). From the viewpoint of handleability and ensuring flatness, the first carrier 12 preferably has a Vickers hardness of 100 HV or more, and more preferably 150 HV or more and 2500 HV or less. As a material satisfying these characteristics, the first carrier 12 is preferably composed of glass, silicon, or ceramic, more preferably glass or ceramic, and particularly preferably glass.

Examples of the first carrier 12 composed of glass include a glass plate. When glass is used as the first carrier 12, the advantages are that it is lightweight, has a low coefficient of thermal expansion, has high insulating properties, and is rigid and has a flat surface to enable the surface of the first metal layer 18 to be extremely smoothed. In addition, when the first carrier 12 is glass, the advantages are that it has surface flatness (coplanarity) advantageous for fine circuit formation, and that it has chemical resistance in desmear and various plating steps in a wiring manufacturing process. Preferred examples of the glass constituting the first carrier 12 include quartz glass, borosilicate glass, alkali-free glass, soda lime glass, aluminosilicate glass, and combinations thereof, more preferably alkali-free glass, soda lime glass, and combinations thereof, and particularly preferably alkali-free glass. The alkali-free glass is glass containing substantially no alkali metals that is mainly composed of silicon dioxide, aluminum oxide, boron oxide, and alkaline earth metal oxides such as calcium oxide and barium oxide as main components and further contains boric acid. This alkali-free glass has an advantage of having a low and stable coefficient of thermal expansion in the range of 3 ppm/K or more and 5 ppm/K or less in a wide temperature zone of 0°C to 350°C, thus enabling the warpage of the glass in a process involving heating to be minimized. The thickness of the first carrier 12 is preferably 100 µm or more and 2000 µm or less, more preferably 300 µm or more and 1800 µm or less, and further preferably 400 µm or more and 1100 µm or less. When the first carrier 12 has a thickness within such a range, it is possible to achieve the thinning of wiring and the still further reduction in warpage, while ensuring suitable strength that does not hinder handling.

The surface of the first carrier 12 on the first release layer 16 side (or, if present, on the first intermediate layer 14 side) preferably has an arithmetic average roughness Ra of 0.1 nm or more and 70 nm or less, more preferably 0.5 nm or more and 60 nm or less, further preferably 1.0 nm or more and 50 nm or less, particularly preferably 1.5 nm or more and 40 nm or less, and most preferably 2.0 nm or more and 30 nm or less, as measured in accordance with JIS B 0601-2001. The smaller the arithmetic average roughness, the lower the arithmetic average roughness Ra achievable on the outer surface of the first metal layer 18, making it suited for forming highly miniaturized wiring patterns.

The first carrier 12 and the second carrier 32 each preferably have a coefficient of linear thermal expansion (CTE) of 2.0 ppm/K or more and 30.0 ppm/K or less, more preferably 2.5 ppm/K or more and 25.0 ppm/K or less, further preferably 3.0 ppm/K or more and 20.0 ppm/K or less, and particularly preferably 3.2 ppm/K or more and 15.0 ppm/K or less. Within such a range, warpage of the carrier itself in a process involving a heat treatment can be suppressed, and warpage of the laminate based on the difference in the coefficient of linear thermal expansion between the carrier and the insulating layer can also be suppressed even more effectively. From the viewpoint of even more effectively suppressing warpage of the laminate based on the difference in the coefficient of linear thermal expansion between the first carrier 12 and the second carrier 32, the ratio (= (C₂/C₁) × 100) of the coefficient of linear thermal expansion C₂ of the second carrier 32 to the coefficient of linear thermal expansion C₁ of the first carrier 12 is preferably 70% or more and 130% or less, more preferably 80% or more and 120% or less, further preferably 90% or more and 110% or less, and most preferably 100%. Furthermore, the ratio (= (T₂/T₁) × 100) of the thickness T₂ of the second carrier 32 to the thickness T₁ of the first carrier 12 is preferably 20% or more and 180% or less, more preferably 40% or more and 160% or less, further preferably 60% or more and 140% or less, further more preferably 80% or more and 120% or less, particularly preferably 90% or more and 110% or less, and most preferably 100%. By doing so, the warpage of the first carrier 12 and the warpage of the second carrier 32 effectively cancel each other out, thereby allowing the warpage of the laminate to be suppressed even more effectively.

The first intermediate layer 14, which is optionally provided, is interposed between the first carrier 12 and the first release layer 16, and serves as a layer that contributes to securing adhesion between the first carrier 12 and the first release layer 16. Examples of the metal constituting the first intermediate layer 14 include Cu, Ti, Al, Nb, Zr, Cr, W, Ta, Co, Ag, Ni, In, Sn, Zn, Ga, Mo, and combinations thereof (hereinafter sometimes referred to as metal M); preferably Cu, Ti, Al, Nb, Zr, Cr, W, Ta, Co, Ag, Ni, Mo, and combinations thereof; more preferably Cu, Ti, Zr, Al, Cr, W, Ni, Mo, and combinations thereof; further preferably Cu, Ti, Al, Cr, Ni, Mo, and combinations thereof; and particularly preferably Cu, Ti, Al, Ni, and combinations thereof. The first intermediate layer 14 may be a pure metal or an alloy. The metal constituting the first intermediate layer 14 may contain impurities resulting from the raw material component, the film formation step, and the like. Moreover, although not particularly limited, in the case of exposure to the air after the film formation of the first intermediate layer 14, the presence of oxygen mixed due to the exposure is allowed. The upper limit of the content of the metal is not particularly limited and may be 100 atomic%. The first intermediate layer 14 is preferably a layer formed by a physical vapor deposition (PVD) method, and more preferably a layer formed by sputtering. The first intermediate layer 14 is particularly preferably a layer formed by a magnetron sputtering method using a metal target from the viewpoint of uniformity of film thickness distribution. The thickness of the first intermediate layer 14 is preferably 10 nm or more and 1000 nm or less, more preferably 30 nm or more and 800 nm or less, further preferably 60 nm or more and 600 nm or less, and particularly preferably 100 nm or more and 400 nm or less. With such a thickness, the intermediate layer can have a roughness equivalent to that of the carrier. This thickness is a value measured by analyzing a layer cross section by a transmission electron microscope-energy dispersive X-ray spectrometer (TEM-EDX).

The first intermediate layer 14 may have a one-layer configuration or a configuration of two or more layers. In the case where the first intermediate layer 14 has a one-layer configuration, the first intermediate layer 14 is preferably composed of a layer containing a metal composed of Cu, Al, Ti, Ni, or a combination thereof (for example, an alloy or an intermetallic compound), more preferably Al, Ti, or a combination thereof (for example, an alloy or an intermetallic compound), and further preferably a layer mainly containing Al or a layer mainly containing Ti. On the other hand, in the case where a metal or an alloy whose adhesion to the first carrier 12 cannot be said to be sufficiently high is adopted in the first intermediate layer 14, it is preferable that the first intermediate layer 14 has a two-layer configuration. That is, by providing a layer composed of a metal (for example, Ti) or an alloy having excellent adhesion to the first carrier 12 adjacent to the first carrier 12, and by providing a layer composed of a metal (for example, Cu) or an alloy having poor adhesion to the first carrier 12 adjacent to the first release layer 16, the adhesion to the first carrier 12 can be improved. Accordingly, preferred examples of the two-layer configuration of the first intermediate layer 14 include a laminated structure composed of a Ti-containing layer adjacent to the first carrier 12 and a Cu-containing layer adjacent to the first release layer 16. In addition, since the release strength varies depending on the constituent elements and the thickness balance of each layer in the two-layer configuration, it is preferable to adjust the constituent elements and thickness of each layer as appropriate. The scope of "metal M-containing layer" as used herein also encompasses alloys containing elements other than metal M to the extent that the releasability from the carrier is not impaired. Accordingly, the first intermediate layer 14 can also be referred to as a layer mainly containing metal M. From the above point, the content of metal M in the first intermediate layer 14 is preferably 50 atomic% or more and 100 atomic% or less, more preferably 60 atomic% or more and 100 atomic% or less, further preferably 70 atomic% or more and 100 atomic% or less, particularly preferably 80 atomic% or more and 100 atomic% or less, and most preferably 90 atomic% or more and 100 atomic% or less.

In the case where the first intermediate layer 14 is composed of an alloy, preferred examples of the alloy include a Ni alloy. The Ni alloy preferably has a Ni content of 45% by weight or more and 98% by weight or less, more preferably 55% by weight or more and 90% by weight or less, and further preferably 65% by weight or more and 85% by weight or less. The preferred Ni alloy is an alloy of Ni with at least one selected from the group consisting of Cr, W, Ta, Co, Cu, Ti, Zr, Si, C, Nd, Nb, and La, and more preferably an alloy of Ni with at least one selected from the group consisting of Cr, W, Cu, and Si. In the case where the first intermediate layer 14 is a Ni alloy layer, it is particularly preferable that the layer is formed by a magnetron sputtering method using a Ni alloy target from the viewpoint of uniformity of film thickness distribution.

The first release layer 16 is a layer that enables or facilitates the release of the first carrier 12 and, when present, the first intermediate layer 14. The first release layer 16 may be a layer that can be released using a laser release method (laser lift-off, LLO) in addition to a layer that can be released using a method of physically applying a force. When the first release layer 16 is composed of a material that can be released by laser lift-off, the first release layer 16 may be composed of a resin with its adhesive strength at the interface reduced by laser beam irradiation after curing, or may be a layer of silicon, silicon carbide, metal oxide, or the like that is modified by laser beam irradiation. The first release layer 16 may be either an organic release layer or an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides including at least one or more of Ni, Mo, Co, Cr, Fe, Ti, W, P, Zn, Cu, Al, Nb, Zr, Ta, Ag, In, Sn, and Ga, or a carbon layer. Among these in particular, the first release layer 16 is preferably a carbon-containing layer, that is, a layer mainly containing carbon, in terms of ease of release, film formation properties, and the like, more preferably a layer mainly composed of carbon or a hydrocarbon, and further preferably a layer composed of amorphous carbon, a hard carbon film. In this case, the first release layer 16 (that is, a carbon-containing layer) preferably has a carbon concentration of 60 atomic% or more, more preferably 70 atomic% or more, further preferably 80 atomic% or more, and particularly preferably 85 atomic% or more as measured by x-ray photoelectron spectroscopy (XPS). The upper limit value of the carbon concentration is not particularly limited and may be 100 atomic% but is practically 98 atomic% or less. The first release layer 16 can contain impurities (for example, oxygen and hydrogen, which are derived from the surrounding environment such as the atmosphere). In the first release layer 16, atoms of metals of types other than the metal contained as the first release layer 16 can be mixed due to the film formation method of the first metal layer 18 or the like. In the case where a carbon-containing layer is used as the first release layer 16, the interdiffusivity and reactivity with the carrier are low, and even if the layer is subjected to pressing at a temperature exceeding 300°C, formation of metal bonds due to high-temperature heating between the first metal layer and the bonding interface can be prevented to maintain a state where the release and removal of the carrier is easy. This first release layer 16 is also preferably a layer formed by a vapor phase method such as sputtering, in terms of suppressing excessive impurities in the first release layer 16 and of enabling continuous production with the film formation of the first intermediate layer 14, which is optionally provided. In the case where a carbon-containing layer is used as the first release layer 16, its thickness is preferably 1 nm or more and 20 nm or less, and more preferably 1 nm or more and 10 nm or less. With such a thickness, the release layer can have a roughness equivalent to that of the carrier and possess a release function. This thickness is a value measured by analyzing a layer cross section by a transmission electron microscope-energy dispersive X-ray spectrometer (TEM-EDX).

The first release layer 16 may be a layer including a metal oxide layer and a carbon-containing layer, respectively, or a layer including both a metal oxide and carbon. Particularly, when the carrier-attached metal foil includes the first intermediate layer 14, the carbon-containing layer can contribute to the stable release of the first carrier 12, and the metal oxide layer can inhibit the diffusion of the metal elements derived from the first intermediate layer 14 and the first metal layer 18, accompanying heating. As a result, even after the heating at a temperature as high as, for example, 350°C or more, stable releasability can be maintained. The metal oxide layer is preferably a layer including an oxide of metals composed of Cu, Ti, Al, Nb, Zr, Cr, W, Ta, Co, Ag, Ni, In, Sn, Zn, Ga, Mo, or combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the first release layer 16 is not particularly limited. The first release layer 16 may be present in a state of a mixed phase in which the boundary between the metal oxide layer and the carbon-containing layer is not clearly identified (that is, a layer containing both metal oxide and carbon).

Similarly, from the viewpoint of maintaining stable releasability even after heat treatment at high temperatures, the first release layer 16 may be a metal-containing layer in which the surface on the side adjacent to the first metal layer 18 is a fluorination-treated surface and/or a nitriding-treated surface. In the metal-containing layer, a region in which the sum of the content of fluorine and the content of nitrogen is 1.0 atomic% or more (hereinafter referred to as a "(F + N) region") is preferably present over a thickness of 10 nm or more, and the (F + N) region is preferably present on the first metal layer 18 side of the metal-containing layer. The thickness (in terms of SiO₂) of the (F + N) region is a value specified by performing the depth profile elemental analysis of the carrier-attached metal foil using XPS. The fluorination-treated surface or the nitriding-treated surface can be preferably formed by reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic% or more and 100 atomic% or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the first release layer 16 may be a metal oxynitride-containing layer instead of a carbon layer or the like. The surface of the metal oxynitride-containing layer opposite to the first carrier 12 (that is, on the first metal layer 18 side) preferably includes at least one metal oxynitride selected from the group consisting of TaON, NiON, TiON, NiWON, and MoON. In terms of ensuring the adhesion between the first carrier 12 and the first metal layer 18, the surface of the metal oxynitride-containing layer on the first carrier 12 side preferably includes at least one selected from the group consisting of Cu, Ti, Ta, Cr, Ni, Al, Mo, Zn, W, TiN, and TaN. Thus, the number of foreign matter particles on the surface of the first metal layer 18 is suppressed to improve circuit formation properties, and even after heating at high temperatures for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The first metal layer 18 is a layer composed of metal. The first metal layer 18 may have a one-layer configuration or a configuration of two or more layers. When the first metal layer 18 is composed of two or more layers, the first metal layer 18 can have a configuration in which metal layers from a first layer to an m-th layer (m is an integer of 2 or more) are laminated in order on the surface side of the first release layer 16 opposite to the first carrier 12. The thickness of the entire first metal layer 18 is preferably 1 nm or more and 2000 nm or less, preferably 100 nm or more and 1500 nm or less, more preferably 200 nm or more and 1000 nm or less, further preferably 300 nm or more and 800 nm or less, and particularly preferably 350 nm or more and 500 nm or less. The thickness of the first metal layer 18 is a value measured by analyzing a layer cross section by a transmission electron microscope-energy dispersive X-ray spectrometer (TEM-EDX). An example in which the first metal layer 18 is composed of two layers, a first layer and a second layer, will be described below.

The first layer in the first metal layer 18 preferably provides the desired functions such as an etching stopper function and an antireflection function to the carrier-attached metal foil. Preferred examples of the metal constituting the first layer include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of being less likely to dissolve in flash etchants (for example, copper flash etchants) and, as a result, can exhibit excellent chemical resistance to flash etchants. Therefore, the first layer is a layer less likely to be etched with a flash etchant than the second layer to be described later, and can thus function as an etching stopper layer capable of delaying progression of etching. In addition, the metal constituting the first layer described above also has the function of preventing the reflection of light, and hence the first layer can also function as an antireflection layer for improving visibility in image inspection (for example, automatic image inspection (AOI)). The first layer may be a pure metal or an alloy. The metal constituting the first layer may contain impurities resulting from the raw material component, the film formation step, and the like. The upper limit of the content of the metal is not particularly limited and may be 100 atomic%. The first layer is preferably a layer formed by a physical vapor deposition (PVD) method, and more preferably a layer formed by sputtering. The thickness of the first layer is preferably 1 nm or more and 500 nm or less, more preferably 10 nm or more and 400 nm or less, further preferably 30 nm or more and 300 nm or less, and particularly preferably 50 nm or more and 200 nm or less.

Preferred examples of the metal constituting the second layer in the first metal layer 18 include the transition elements of groups 4, 5, 6, 9, 10, and 11, Al, and combinations thereof (for example, alloys and intermetallic compounds), more preferably the transition elements of groups 4 and 11, Al, Nb, Co, Ni, Mo, and combinations thereof, further preferably the transition elements of group 11, Ti, Al, Mo, and combinations thereof, particularly preferably Cu, Ti, Mo, and combinations thereof, and most preferably Cu. The second layer may be manufactured by any method and may be a metal foil formed by, for example, wet film formation methods such as an electroless metal plating method and an electrolytic metal plating method, physical vapor deposition (PVD) methods such as sputtering and vacuum deposition, chemical vapor film formation, or combinations thereof. A particularly preferred second layer is a metal layer formed by physical vapor deposition (PVD) methods such as a sputtering method and vacuum deposition, most preferably a metal layer manufactured by a sputtering method, from the viewpoint of being easily adapted to a fine pitch due to superthinning. The second layer is preferably a metal layer without roughening treatment, but may be one in which secondary roughening is performed by preliminary roughening, soft etching treatment, rinse treatment, or oxidation-reduction treatment, as long as wiring pattern formation is not hindered. From the viewpoint of being adapted to a fine pitch, the thickness of the second layer is preferably 10 nm or more and 1000 nm or less, more preferably 20 nm or more and 900 nm or less, further preferably 30 nm or more and 700 nm or less, further more preferably 50 nm or more and 600 nm or less, particularly preferably 70 nm or more and 500 nm or less, and most preferably 100 nm or more and 400 nm or less. The metal layer having a thickness within such a range is preferably manufactured by a sputtering method from the viewpoint of the in-plane uniformity of film formation thickness, and productivity in a sheet form or a roll form.

When the first metal layer 18 has a one-layer configuration, the second layer described above is preferably adopted as it is as the first metal layer 18. On the other hand, when the first metal layer 18 has an n-layer (n is an integer of 3 or more) configuration, the layers from the first to the (n-1)th in the first metal layer 18 preferably have the configuration of the first layer described above, and the outermost layer, that is, the n-th metal layer, in the first metal layer 18 preferably has the configuration of the second layer described above.

The first intermediate layer 14 (if present), the first release layer 16, and the first metal layer 18 are preferably all physical vapor deposition (PVD) films, that is, films formed by a physical vapor deposition (PVD) method, and more preferably sputter films, that is, films formed by a sputtering method.

The end face of the first carrier 12 is preferably covered by the extension of the first metal layer 18, optionally the first intermediate layer 14, and optionally the first release layer 16 (that is, at least the first metal layer 18, for example, the first metal layer 18 and the first intermediate layer 14) to the end face. That is, not only the surface but also the end face of the first carrier 12 is preferably covered with at least the first metal layer 18. By covering the end face as well, it is possible to prevent the infiltration of chemical liquids into the first carrier 12 in the wiring substrate manufacturing process, and also to strongly prevent chipping due to release at the side end when the carrier-attached metal foil is handled, that is, chipping of the film on the first release layer 16 (that is, the first metal layer 18). The covered region on the end face of the first carrier 12 is preferably a region 0.1 mm or more and more preferably 0.2 mm or more from the surface of the first carrier 12 toward the thickness direction (that is, the direction perpendicular to the carrier surface), and is further preferably throughout the end face of the first carrier 12.

The thickness of the entire carrier-attached metal foil is not particularly limited, but is preferably 500 µm or more and 3000 µm or less, more preferably 700 µm or more and 2500 µm or less, further preferably 900 µm or more and 2000 µm or less, and particularly preferably 1000 µm or more and 1700 µm or less. The size of the carrier-attached metal foil is not particularly limited, but is preferably a diameter of 10 cm or more or 10 cm square or more, more preferably a diameter of 20 cm or more or 20 cm square or more, and further preferably a diameter of 25 cm or more or 25 cm square or more. The upper limit of the size of the carrier-attached metal foil is not particularly limited, but a diameter of 1000 cm or 1000 cm square can be cited as one reference. In addition, the carrier-attached metal foil is in a form that can be handled individually by itself.

### Laminate

According to a preferred aspect of the present invention, there is provided a laminate including the carrier-attached metal foil described above. This laminate includes the carrier-attached metal foil, a first redistribution layer 20 provided on the first metal layer 18 of the carrier-attached metal foil, and a second redistribution layer 40 or insulating layer provided on the second metal layer 38 (or, if the second release layer 36 and the second metal layer 38 are not present, on the second carrier 32). Moreover, it is preferable that the laminate further includes a first build-up layer 46 provided on the first redistribution layer 20 and a second build-up layer 48 provided on the second redistribution layer 40 or insulating layer. The laminate according to the present aspect corresponds to the third laminate 44 or the fourth laminate 50 in the method for manufacturing a redistribution laminate described above, and therefore, by using this laminate, it is possible to manufacture a redistribution laminate in which warpage is suppressed. Preferred aspects of the first redistribution layer 20, the second redistribution layer 40, the first build-up layer 46, and the second build-up layer 48 are as described above.

### EXAMPLES

The present invention will be described more specifically by the following examples. However, the present invention is not limited to the following examples.

### Example A1

After forming an insulating layer on a metal layer of a carrier-attached metal foil to prepare each of a first laminate and a second laminate, they were bonded to obtain a third laminate. Also, the degree of warpage was observed for the obtained first laminate and third laminate. Specifically, the procedure was as follows.

### (1) Preparing First Laminate

A glass substrate (material: soda lime glass, coefficient of linear thermal expansion: 8.5 ppm/K) with a size of 236.4 mm × 241.0 mm and a thickness of 1.1 mm was provided as the first carrier 12. On the first carrier 12, a titanium layer (thickness 50 nm) and a copper layer (thickness 200 nm) as the first intermediate layer 14 having a two-layer configuration, an amorphous carbon layer (thickness 6 nm) as the first release layer 16, and a titanium layer (thickness 100 nm) and a copper layer (thickness 300 nm) as the first metal layer 18 having a two-layer configuration were deposited by sputtering in this order to obtain the first carrier-attached metal foil 10. At this time, the first metal layer 18 was deposited so as to extend out to the end surfaces of the first carrier 12, thereby covering the end portions of the first release layer 16.

An interlayer insulating material (GX-T31, manufactured by Ajinomoto Fine-Techno Co., Inc., thickness 20 µm) was laminated onto the first metal layer 18 of the first carrier-attached metal foil 10, and a lamination treatment was carried out using a vacuum laminator (MVLP-500/600, manufactured by Meiki Co., Ltd.) under the conditions of a temperature of 100°C and a pressure of 0.55 MPa for 60 seconds. Thereafter, a heat curing treatment was carried out at a temperature of 100°C for 30 minutes, and furthermore, a heat curing treatment was carried out at a temperature of 190°C for 30 minutes, thereby forming an insulating layer. By repeating the above operation five times, the insulating layer 20b with a thickness of 100 µm was formed to obtain the first laminate 22. Note that, since the present example aims at confirming the degree of warpage in the laminate, no wiring layer was formed; however, by forming a wiring layer before laminating each insulating layer, for example, the first laminate 22 including the first redistribution layer 20 can be obtained.

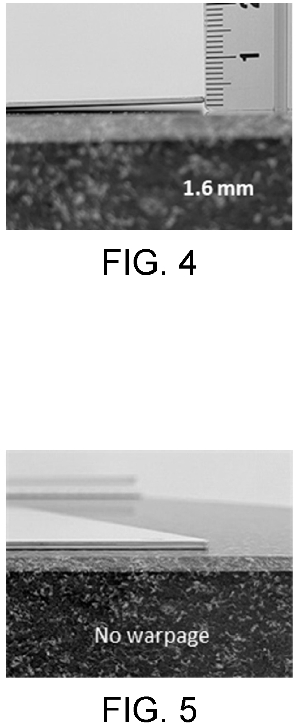

The obtained first laminate 22 was placed on a flat surface of a stage, and the warpage at an end portion of the first laminate 22 (the height from the flat surface to the bottom surface of the first carrier 12) was measured with a ruler (see Figure 4). The result was as shown in Table 1.

### (2) Preparing Second Laminate

In the same manner as in (1) above, the insulating layer 40b was formed on the second metal layer 38 of the second carrier-attached metal foil 30 including the second carrier 32, the second intermediate layer 34, the second release layer 36, and the second metal layer 38 in this order to obtain the second laminate 42.

### (3) Bonding First Laminate and Second Laminate

Using a roll laminator (MP-600, manufactured by MCK Co., Ltd.), an adhesive film made of thermosetting epoxy resin (TSA-1602, manufactured by Toray Industries, Inc., thickness 20 µm) was laminated as the adhesive layer 24 onto the surface on the first carrier 12 side of the first laminate 22 under the condition of a roll temperature of 100°C. Then, under the same roll condition, the first carrier 12 of the first laminate 22 and the second carrier 32 of the second laminate 42 were bonded via the adhesive layer 24 described above. Thereafter, a heat curing treatment was carried out at a temperature of 100°C for 60 minutes, and furthermore, a heat curing treatment was carried out at a temperature of 170°C for 120 minutes, thereby curing the adhesive layer 24 to obtain the third laminate 44. When an end portion of the obtained third laminate 44 was observed by the same method as for the first laminate 22 (see Figure 5), no occurrence of warpage was observed.

### Example A2

The preparation of the first laminate 22, the second laminate 42, and the third laminate 44 was carried out in the same manner as in Example A1, except that borosilicate glass (coefficient of linear thermal expansion: 3.2 ppm/K) was used instead of soda lime glass as the first carrier 12 and the second carrier 32. The results of observing warpage at the end portions of the first laminate 22 and the third laminate 44 were as shown in Table 1.

### Example A3

The preparation of the first laminate 22, the second laminate 42, and the third laminate 44 was carried out in the same manner as in Example A1, except that the number of repetitions of the lamination of the interlayer insulating material and the heat curing treatments was changed to three times to form the insulating layers 20b and 40b with a thickness of 60 µm. The results of observing warpage at the end portions of the first laminate 22 and the third laminate 44 were as shown in Table 1.

### Example A4

The preparation of the first laminate 22, the second laminate 42, and the third laminate 44 was carried out in the same manner as in Example A2, except that the number of repetitions of the lamination of the interlayer insulating material and the heat curing treatments was changed to three times to form the insulating layers 20b and 40b with a thickness of 60 µm. The results of observing warpage at the end portions of the first laminate 22 and the third laminate 44 were as shown in Table 1.

### Example A5

The preparation of the first laminate 22, the second laminate 42, and the third laminate 44 was carried out in the same manner as in Example A1, except that the preparation steps of the first laminate and the second laminate were changed as described in a) and b) below, respectively. The results of observing warpage at the end portions of the first laminate 22 and the third laminate 44 were as shown in Table 1.
a) By alternately forming five layers each of a wiring layer composed of copper by a coreless build-up method and an insulating layer composed of the interlayer insulating material described above on the first metal layer 18 of the first carrier-attached metal foil 10, the first laminate 22 including the first redistribution layer 20 with a thickness of 100 µm was prepared.
b) In the same manner as in a) above, the second laminate 42 including the second redistribution layer 40 with a thickness of 100 µm was prepared.

### Example A6

The preparation of the first laminate 22, the second laminate 42, and the third laminate 44 was carried out in the same manner as in Example A5, except that borosilicate glass (coefficient of linear thermal expansion: 3.2 ppm/K) was used instead of soda lime glass as the first carrier 12 and the second carrier 32. The results of observing warpage at the end portions of the first laminate 22 and the third laminate 44 were as shown in Table 1.

### [Table 1]

**Table 1**

| | First laminate and second laminate | | Warpage of laminate | |
|---|---|---|---|---|
| | Thickness of redistribution layer or insulating layer (µm) | Coefficient of linear thermal expansion of carrier (ppm/K) | First laminate (mm) | Third laminate (mm) |
| Ex. A1 | 100 (insulating layer) | 8.5 | 1.6 | 0 |
| Ex. A2 | 100 (insulating layer) | 3.2 | 2.0 | 0 |
| Ex. A3 | 60 (insulating layer) | 8.5 | 0.9 | 0 |
| Ex. A4 | 60 (insulating layer) | 3.2 | 1.2 | 0 |
| Ex. A5 | 100 (redistribution layer) | 8.5 | 2.1 | 0 |
| Ex. A6 | 100 (redistribution layer) | 3.2 | 2.5 | 0 |

### Example B1

The carrier-attached metal foil of the present invention was prepared according to the procedure shown in Figure 6. Thereafter, insulating layers were formed on both surfaces of the carrier-attached metal foil to obtain a laminate. Also, the obtained laminate was observed for the presence or absence of warpage occurrence. Specifically, the procedure was as follows.

### (1) Preparing Carrier-Attached Metal Foil

First, a glass substrate (material: soda lime glass, coefficient of linear thermal expansion: 8.5 ppm/K) with a size of 300 mm × 300 mm and a thickness of 1.1 mm was provided as the first carrier 12. On the first carrier 12, a titanium layer (thickness 50 nm) and a copper layer (thickness 200 nm) as the first intermediate layer 14 having a two-layer configuration, an amorphous carbon layer (thickness 6 nm) as the first release layer 16, and a titanium layer (thickness 100 nm) and a copper layer (thickness 300 nm) as the first metal layer 18 having a two-layer configuration were deposited by sputtering in this order to obtain the first carrier-attached metal foil 10 (see Figure 6(i)). At this time, the first metal layer 18 was deposited so as to extend out to the end surfaces of the first carrier 12, thereby covering the end portions of the first release layer 16.

Using a roll laminator (MP-600, manufactured by MCK Co., Ltd.), an adhesive film made of thermosetting epoxy resin (TSA-1602, manufactured by Toray Industries, Inc., thickness 20 µm) was laminated as the adhesive layer 24 onto the surface on the first carrier 12 side of the first carrier-attached metal foil 10 under the condition of a roll temperature of 100°C, and a polyethylene terephthalate (PET) film serving as a substrate supporting the adhesive layer 24 was peeled off (see Figure 6(ii)).

The second carrier-attached metal foil 30 was prepared by the same procedure as for the first carrier-attached metal foil 10 described above. That is, the second carrier-attached metal foil 30 includes the second carrier 32, the second intermediate layer 34, the second release layer 36, and the second metal layer 38 in this order (see Figure 6(iii)). The first carrier-attached metal foil 10 and the second carrier-attached metal foil 30 were bonded via the adhesive layer 24 so that the second carrier 32 of the second carrier-attached metal foil 30 was in contact with the surface of the adhesive layer 24 from which the PET film had been peeled off. Thereafter, a heat curing treatment was carried out at a temperature of 100°C for 60 minutes, and furthermore, a heat curing treatment was carried out at a temperature of 170°C for 120 minutes, thereby curing the adhesive layer 24. In this way, a carrier-attached metal foil in which the first carrier-attached metal foil 10 and the second carrier-attached metal foil 30 were laminated in an up-down symmetric manner was obtained (see Figure 6(iv)).

### (2) Preparing Laminate

An interlayer insulating material (GX-T31, manufactured by Ajinomoto Fine-Techno Co., Inc., thickness 35 µm) was laminated onto both surfaces of the obtained carrier-attached metal foil, and a vacuum lamination treatment was carried out using a vacuum laminator (MVLP-500/600, manufactured by Meiki Co., Ltd.) under the conditions of a temperature of 100°C and a pressure of 0.7 Pa for 60 seconds. Thereafter, a first heat curing treatment at a temperature of 100°C for 30 minutes, a second heat curing treatment at a temperature of 170°C for 30 minutes, and a third heat curing treatment at a temperature of 190°C for 60 minutes were carried out, thereby forming an insulating layer with a thickness of about 35 µm. Note that, since the present example aims at confirming the presence or absence of warpage occurrence in the laminate, no wiring layer was formed; however, by forming a wiring layer before and after laminating the insulating layer, for example, a laminate including a redistribution layer can be obtained.

The obtained laminate was placed on a flat surface of a stage, and an attempt was made to measure the warpage at an end portion of the laminate (the height from the flat surface to the bottom surface of the insulating layer) with a ruler; however, no warpage was observed in the laminate (that is, the warpage was 0 mm).

### Example B2

A laminate was prepared in the same manner as in Example B1, except that an insulating layer with a thickness of about 70 µm was formed on both surfaces of the carrier-attached metal foil in (2) above. The obtained laminate was placed on a flat surface of a stage, and an attempt was made to measure the warpage at an end portion of the laminate (the height from the flat surface to the bottom surface of the insulating layer) with a ruler; however, no warpage was observed in the laminate (that is, the warpage was 0 mm).

### Example B3

A laminate was prepared in the same manner as in Example B1, except that an insulating layer with a thickness of about 100 µm was formed on both surfaces of the carrier-attached metal foil in (2) above. The obtained laminate was placed on a flat surface of a stage, and an attempt was made to measure the warpage at an end portion of the laminate (the height from the flat surface to the bottom surface of the insulating layer) with a ruler; however, no warpage was observed in the laminate (that is, the warpage was 0 mm).

## Claims

1. A method for manufacturing a redistribution laminate, comprising the steps of:
forming a first redistribution layer with a thickness of 100 µm or less on a first metal layer of a first carrier-attached metal foil comprising a first carrier, a first release layer, and the first metal layer in this order to obtain a first laminate;
providing a second laminate comprising a second redistribution layer or dummy insulating layer with a thickness of 100 µm or less on a second carrier; and
bonding the first carrier of the first laminate and the second carrier of the second laminate via an adhesive layer containing an adhesive material to obtain a third laminate.

2. The method for manufacturing a redistribution laminate according to claim 1, further comprising the step of forming a first build-up layer on the first redistribution layer of the third laminate and also forming a second build-up layer on the second redistribution layer or dummy insulating layer of the third laminate to obtain a fourth laminate.

3. The method for manufacturing a redistribution laminate according to claim 2, further comprising the step of releasing the first carrier from the fourth laminate.

4. The method for manufacturing a redistribution laminate according to any one of claims 1 to 3,
wherein the second laminate comprises the second redistribution layer, and
wherein the step of providing the second laminate comprises forming the second redistribution layer on a second metal layer of a second carrier-attached metal foil comprising the second carrier, a second release layer, and the second metal layer in this order.

5. The method for manufacturing a redistribution laminate according to any one of claims 1 to 3, wherein each of the first carrier and the second carrier has a coefficient of linear thermal expansion of 2.0 ppm/K or more and 30.0 ppm/K or less.

6. The method for manufacturing a redistribution laminate according to any one of claims 1 to 3, wherein a ratio T_{R2}/T_{R1} of a thickness T_{R2} of the second redistribution layer or the dummy insulating layer to a thickness T_{R1} of the first redistribution layer is 0.1 or more and 30.0 or less.

7. The method for manufacturing a redistribution laminate according to any one of claims 1 to 3,
wherein the step of forming the first redistribution layer comprises the steps of:
forming a first wiring layer on a surface of the first metal layer; and
alternately forming an insulating layer and a wiring layer on the surface of the first carrier-attached metal foil where the first wiring layer has been formed to obtain the first redistribution layer in which the first wiring layer is incorporated as an embedded wiring layer.

8. The method for manufacturing a redistribution laminate according to claim 7, wherein the insulating layer is composed of an insulating resin comprising at least one selected from the group consisting of a thermosetting epoxy resin, a thermosetting polyimide resin, and a thermosetting phenolic resin.

9. The method for manufacturing a redistribution laminate according to any one of claims 1 to 3, wherein the adhesive material comprises a solvent-free adhesive.

10. The method for manufacturing a redistribution laminate according to any one of claims 1 to 3, wherein the adhesive material comprises at least one selected from the group consisting of a thermosetting epoxy resin, a thermosetting polyimide resin, a photosensitive polyimide resin, an acrylic resin, and a phenolic resin.

11. The method for manufacturing a redistribution laminate according to any one of claims 1 to 3, wherein the adhesive layer has a thickness of 5 µm or more and 1000 µm or less.

12. The method for manufacturing a redistribution laminate according to claim 2 or 3, wherein each of the first build-up layer and the second build-up layer has a thickness of 20 µm or more.

13. The method for manufacturing a redistribution laminate according to claim 2 or 3, wherein a ratio T_{B2}/T_{B1} of a thickness T_{B2} of the second build-up layer to a thickness T_{B1} of the first build-up layer is 0.5 or more and 1.5 or less.

14. The method for manufacturing a redistribution laminate according to claim 2 or 3, wherein each of the first build-up layer and the second build-up layer comprises a prepreg.

15. A carrier-attached metal foil comprising:
a first carrier;
a first release layer provided on the first carrier;
a first metal layer provided on the first release layer;
an adhesive layer containing an adhesive material, provided on a surface of the first carrier on an opposite side to the first release layer; and
a second carrier provided on the first carrier via the adhesive layer.

16. The carrier-attached metal foil according to claim 15, further comprising:
a second release layer provided on the second carrier; and
a second metal layer provided on the second release layer.

17. A laminate comprising:
the carrier-attached metal foil according to claim 16;
a first redistribution layer provided on the first metal layer of the carrier-attached metal foil; and
a second redistribution layer or an insulating layer provided on the second metal layer of the carrier-attached metal foil.

18. The laminate according to claim 17, further comprising:
a first build-up layer provided on the first redistribution layer; and
a second build-up layer provided on the second redistribution layer or the insulating layer.
